(19)

Europäisches
Patentamt
European
Patent Office
Office européen
des brevets

(11) **EP 3 264 235 A1**

(12) **EUROPEAN PATENT APPLICATION**
published in accordance with Art. 153(4) EPC

(43) Date of publication:
**03.01.2018 Bulletin 2018/01**

(21) Application number: **16755731.3**

(22) Date of filing: **26.02.2016**

(51) Int Cl.:
*G06F 3/041* [(2006.01)]   *G06F 3/044* [(2006.01)]
*H05K 1/02* [(2006.01)]   *H05K 3/12* [(2006.01)]
*H05K 3/20* [(2006.01)]

(86) International application number:
**PCT/JP2016/055931**

(87) International publication number:
**WO 2016/136987 (01.09.2016 Gazette 2016/35)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority: **27.02.2015 JP 2015038637**

(71) Applicant: **Fujikura Ltd.
Tokyo 135-8512 (JP)**

(72) Inventor: **SHIOJIRI, Takeshi
Sakura-shi,
Chiba 285-8550 (JP)**

(74) Representative: **Ter Meer Steinmeister & Partner
Patentanwälte mbB
Artur-Ladebeck-Strasse 51
33617 Bielefeld (DE)**

(54) **WIRING BODY, WIRING SUBSTRATE, TOUCH SENSOR, AND METHOD FOR PRODUCING WIRING BODY**

(57)   A wiring body (3) includes a resin layer (31), an electrode layer (320) provided on a surface of the resin layer (31) at one side, and a lead wiring layer (324) provided on the surface of the resin layer (31) at the one side and formed integrally with the electrode layer (320). The lead wiring layer (324) has a single-layer structure made of a material having the same composition as that of a material constituting the electrode layer (320). A following Expression (1) is satisfied: $T_1 < T_2 \ldots(1)$. In the above Expression (1), $T_1$ is a thickness of the electrode layer (320), and $T_2$ is a thickness of the lead wiring layer (324).

Fig.7 (A)

EP 3 264 235 A1

Fig.7 (B)

Fig.7 (D)

Fig.7 (E)

Fig.7 (C)

## Description

[Technical Field]

The present invention relates to a wiring body, a wiring board, a touch sensor, and a production method for a wiring body.

The contents of Patent Application No. 2015-038637, filed with Japan Patent Office on February 27, 2015, are incorporated herein by reference in the designated countries in which the incorporation by reference is accepted.

[Background Art]

A production method is known for an electromagnetic-wave shielding material having a conductive layer that is formed with a predetermined pattern on one surface of a transparent base material (see Patent Document 1, for example). This production method includes first preparing a recessed plate having a recess of a shape corresponding to the pattern of the conductive layer and filling the recess with a conductive composition. This method further includes forming a primer layer on one surface of the base material, bringing the primer layer into close contact with the recessed plate, curing the primer layer, then releasing the transparent base material and the primer layer from the recessed plate, and thereafter curing the conductive composition.

[Prior Art Document]

[Patent Document]

[Patent Document 1] JP4436441B

[Summary of Invention]

[Problems to be solved by Invention]

If a wiring body including electrode parts and lead wiring parts is produced using the above technique, the lead wiring parts will be formed of conductive layers having the same thickness as that of the electrode parts and, therefore, unfortunately, the electric resistance value may be high in the lead wiring parts.

Problems to be solved by the present invention include providing a wiring body, a wiring board, a touch sensor, and a production method for a wiring body that are able to suppress increase of the electric resistance value in lead wiring parts.

[Means for solving problems]

<1> The wiring body according to the present invention comprises: a resin layer; an electrode layer provided on a surface of the resin layer at one side and having at least one first line-like conductor layer; and a lead wiring layer provided on the surface of the resin layer at the one side and having at least one second line-like conductor layer that is formed integrally with the electrode layer. The lead wiring layer has a single-layer structure made of a material having the same composition as that of a material of which the electrode layer is made. A following Expression (1) is satisfied:

$$T_1 < T_2 \ \ldots (1).$$

In the above Expression (1), $T_1$ is a thickness of the first line-like conductor layer, and $T_2$ is a thickness of the second line-like conductor layer.

<2> In the above invention, a following Expression (2) may be satisfied:

$$H_1 < H_2 \ \ldots (2).$$

In the above Expression (2), $H_1$ is a height from a surface of the resin layer at the other side to a surface of the first line-like conductor layer at the one side, and $H_2$ is a height from the surface of the resin layer at the other side to a surface of the second line-like conductor layer at the one side.

<3> In the above invention, an aspect ratio (width/thickness) of the second line-like conductor layer in its cross-sectional view may be one or more.

<4> In the above invention, a following Expression (3) may be satisfied:

$$W_1 < W_2 \ \ldots (3).$$

In the above Expression (3), $W_1$ is a width of the first line-like conductor layer in its cross-sectional view, and $W_2$ is a width of the second line-like conductor layer in its cross-sectional view.

<5> In the above invention, the thickness $W_1$ of the first line-like conductor layer may be 10 $\mu$m or less.

<6> In the above invention, a first adhesion surface between the first line-like conductor layer and the resin layer may be convexly curved toward the first line-like conductor layer in its cross-sectional view, a second adhesion surface between the second line-like conductor layer and the resin layer may be convexly curved toward the second line-like conductor layer in its cross-sectional view, and a following Expression (4) is satisfied:

$$R_1 < R_2 \ \ldots (4).$$

In the above Expression (4), $R_1$ is a curvature of the first adhesion surface, and $R_2$ is a curvature of the second adhesion surface.

<7> In the above invention, a following Expression (5) may be satisfied:

$$S_1 < S_2 \ \ldots (5).$$

In the above Expression (5), $S_1$ is a thickness of the resin layer at an adhesion portion with the first line-like conductor layer, and $S_2$ is a thickness of the resin layer at an adhesion portion with the second line-like conductor layer.

<8> In the above invention, a surface of the first line-like conductor layer at the one side may be located at a side departing from the resin layer in a thickness direction of the resin layer as compared with at least a part of the second adhesion surface.

<9> In the above invention, the first line-like conductor layer and the second line-like conductor layer may connect to each other in a connection portion between the electrode layer and the lead wiring layer, and

a thickness of a conductor portion in the connection portion may increase continuously toward the second line-like conductor layer from the first line-like conductor layer.

<10> In the above invention, the electrode layer may have a plurality of the first line-like conductor layers provided on the surface of the resin layer at the one side, and a shape of the electrode layer in its plan view may be a mesh shape configures by the plurality of the first line-like conductor layers.

<11> In the above invention, the lead wiring layer may have a plurality of the second line-like conductor layers provided on the surface of the resin layer at the one side, and a shape of the lead wiring layer in its plan view may be a mesh shape configured by the plurality of the second line-like conductor layers.

<12> The wiring board according to the present invention comprises the above wiring body and a support body supporting the wiring body.

<13> The touch sensor according to the present invention comprises the above wiring board.

<14> The production method for a wiring body according to the present invention is a production method for a wiring body that includes an electrode layer and a lead wiring layer formed integrally with the electrode layer. The production method comprises: a first step of filling a recess of a recessed plate with a conductive material; a second step of performing at least one of drying, heating, and irradiation with energy rays for the conductive material with which the recess is filled; a third step of disposing a resin on the conductive material; and a fourth step of releasing at least the resin and the conductive material from the recessed plate. The recess includes: a first recess corresponding to a shape of the electrode layer; and a second recess corresponding to a shape of the lead wiring layer. The lead wiring layer has a single-layer structure made of a material having the same composition as that of a material of which the electrode layer is made. A following Expression (6) is satisfied:

$$D_1 < D_2 \ \ldots (6).$$

In the above Expression (6), $D_1$ is a depth of the first recess, and $D_2$ is a depth of the second recess.

[Effect of Invention]

According to the present invention, the electrode layer provided on one surface of the resin layer and the lead wiring layer formed integrally with the electrode layer satisfy the above Expression (1). This can increase the cross-sectional area of the lead wiring layer as compared with a lead wiring layer having the same thickness as that of the electrode layer. It is thus possible to suppress increase in the electric resistance value of the lead wiring layer.

[Brief Description of Drawings]

FIG. 1 is a plan view illustrating a wiring body in an embodiment of the present invention.
FIG. 2 is a cross-sectional view along line II-II of FIG. 1.
FIG. 3 is a cross-sectional view for describing a first line-like conductor layer in an embodiment of the present invention.
FIG. 4 is a cross-sectional view along line IV-IV of FIG. 1.
FIG. 5 is a view illustrating a connection portion between an electrode layer and a lead wiring layer in an embodiment of the present invention, that is, a cross-sectional view along line V-V of FIG. 1.
FIG. 6 is a view illustrating a modified example of the connection portion between an electrode layer and a lead wiring layer in an embodiment of the present invention, that is, a view corresponding to the cross-section along line V-V of FIG. 1.
FIG. 7(A) to FIG. 7(E) are cross-sectional views for describing a production method for a wiring body in an embodiment of the present invention.

[Mode(s) for Carrying out the Invention]

Hereinafter, one or more embodiments of the present invention will be described with reference to the drawings.

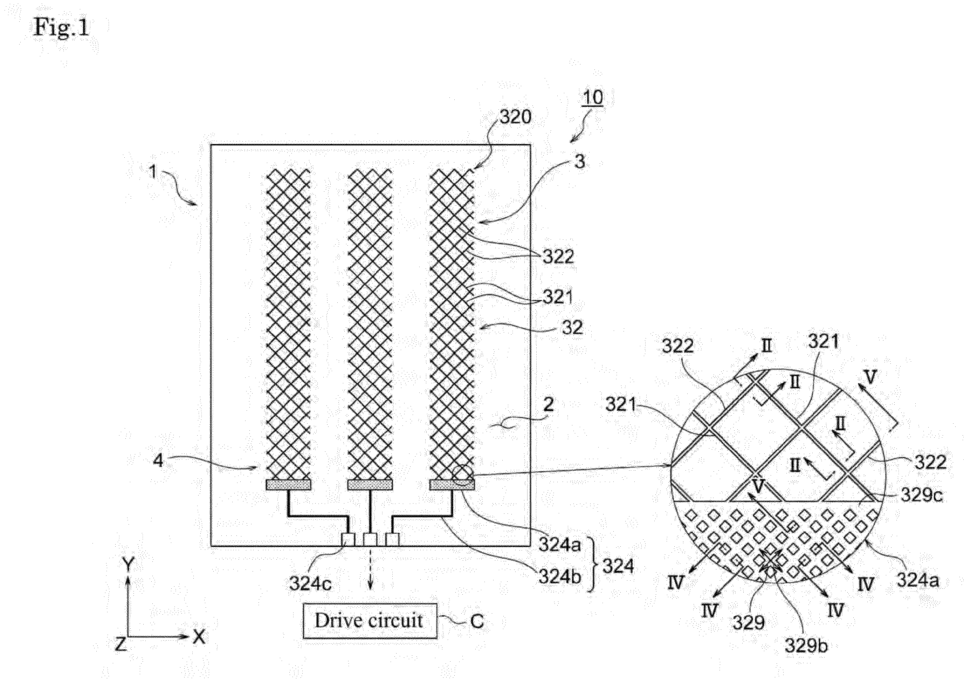

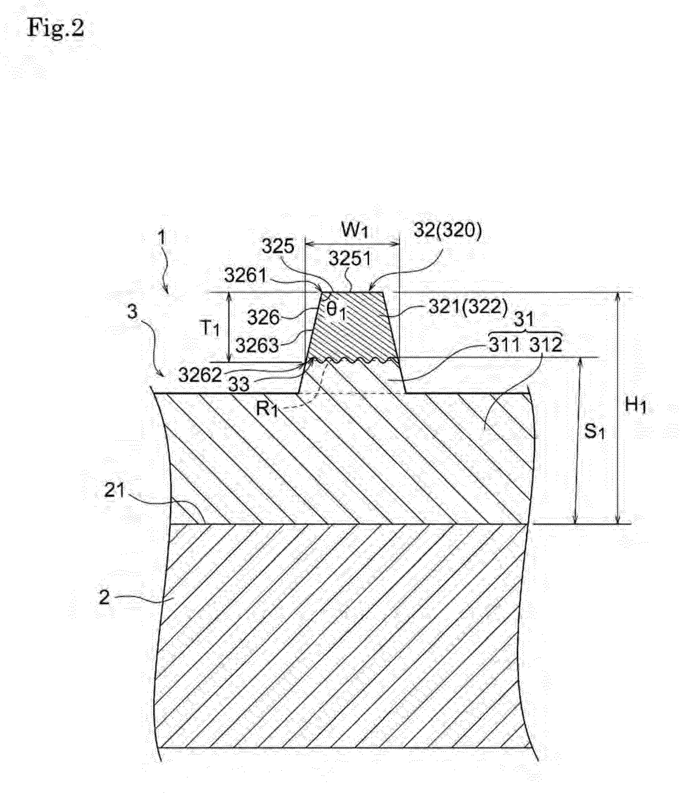

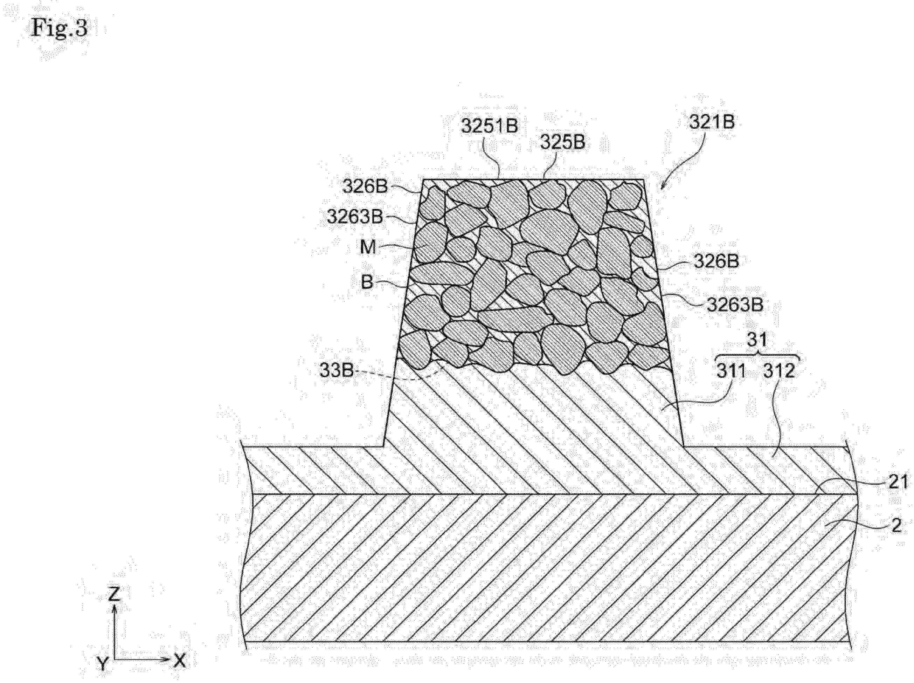

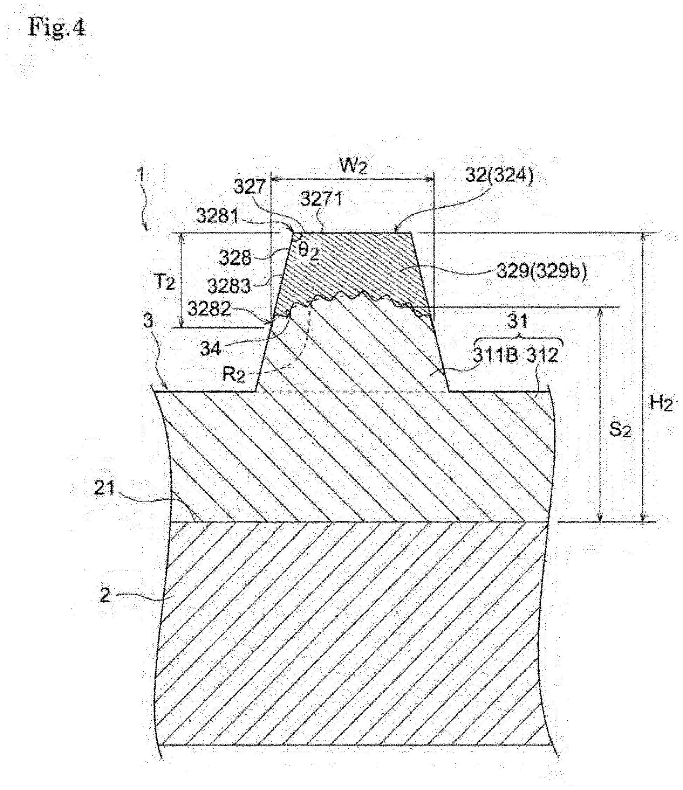

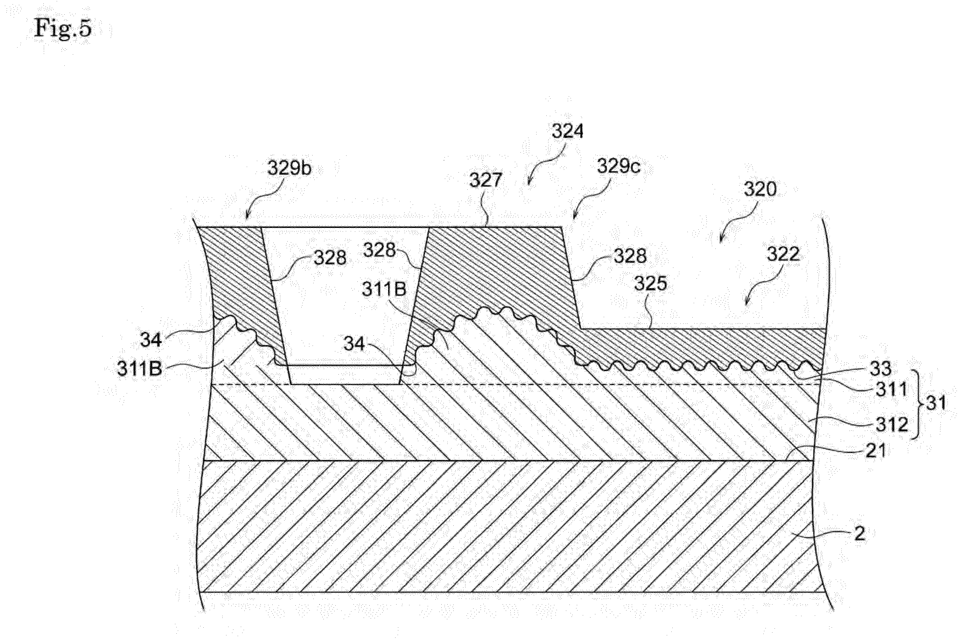

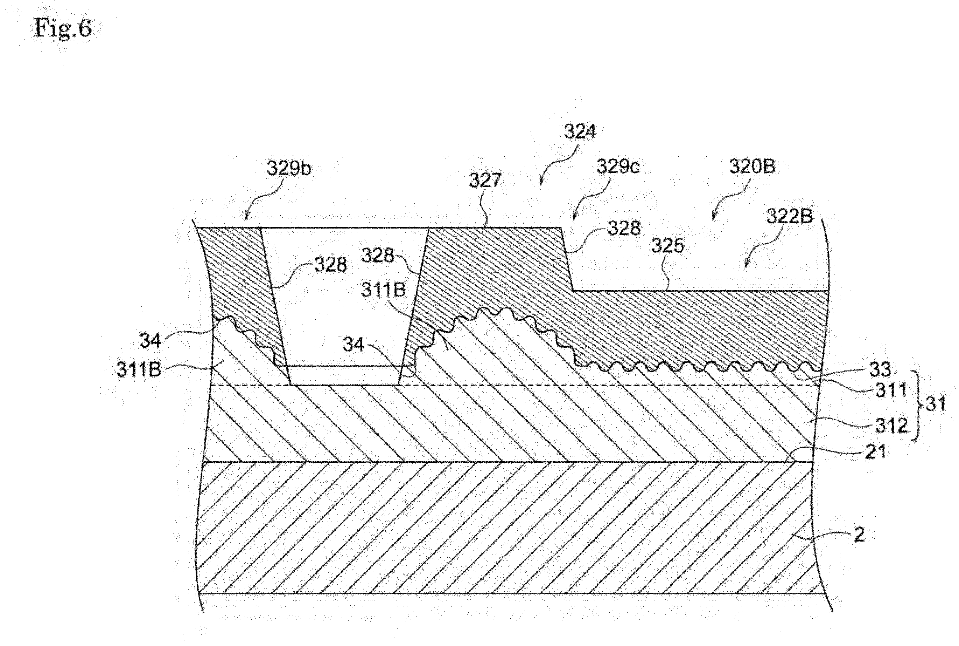

FIG. 1 is a plan view illustrating a wiring body in an embodiment of the present invention, FIG. 2 is a cross-sectional view along line II-II of FIG. 1, FIG. 3 is a cross-sectional view for describing a first line-like conductor layer in an embodiment of the present invention, FIG. 4 is a cross-sectional view along line IV-IV of FIG. 1, FIG. 5 is a view illustrating a connection portion between an electrode layer and a lead wiring layer in an embodiment of the present invention, that is, a cross-sectional view along line V-V of FIG. 1, and FIG. 6 is a view illustrating a modified example of the connection portion between an electrode layer and a lead wiring layer in an embodiment of the present invention, that is, a view corresponding to the cross-section along line V-V of FIG. 1.

Touch sensor 10 comprising a wiring body 3 in the present embodiment is, for example, a touch input device, such as used in a capacitance-type touch panel or touch pad. The touch sensor 10 includes a wiring board 1 and a second wiring body that is provided above the wiring body 3, which is included in the wiring board 1, via a resin layer. In FIG. 1, the resin layer and the second wiring body are not illustrated. The wiring board 1 in the present embodiment includes a substrate 2 and the wiring body 3. The "touch sensor 10" in the present embodiment corresponds to an example of the "touch sensor" in the present invention and the "wiring board 1" in the present embodiment corresponds to an example of the "wiring board" in the present invention.

The substrate 2 has a rectangular shape as illustrated in FIG. 1 and is composed of a film of polyethylene terephthalate (PET). The material of which the substrate 2 is made not particularly limited to the above. Examples of the material include polyethylene naphthalate (PEN), polyimide resin (PI), polyetherimide resin (PEI), polycarbonate (PC), polyether ether ketone (PEEK), liquid-crystal polymer (LCP), cycloolefin polymer (COP), silicone resin (SI), acrylic resin, phenol resin, epoxy resin, green sheet, and glass. Such a substrate may be formed with an easy-adhesion layer and/or an optical adjustment layer. In an embodiment, a display or a cover panel may be used as the substrate 2. The shape of the substrate 2 is not particularly limited. The thickness of the substrate 2 is not particularly limited, but may be preferably 1 $\mu$m to 2 mm, further preferably 10 $\mu$m to 500 $\mu$m, and furthermore preferably 10 $\mu$m to 100 $\mu$m. The "substrate 2" in the present embodiment corresponds to an example of the "support body" in the present invention.

The wiring body 3 in the present embodiment includes an adhesion layer 31 and a conductor layer 32.

The adhesion layer 31 as a resin layer is a layer that adheres to the substrate 2 and the conductor layer 32 to fix them to each other. As illustrated in FIG. 2 or FIG. 3, the adhesion layer 31 is provided on the entire area of a main surface 21 of the substrate 2. Examples of an adhesive material that constitutes the adhesion layer 31 include a UV-curable resin, a thermoset resin, and a thermoplastic resin, such as an epoxy resin, acrylic resin, polyester resin, urethane resin, vinyl resin, silicone resin, phenol resin, and polyimide resin. The adhesion layer 31 has: support parts 311 and 311B that respectively support first line-like conductor layers 321 and 322 and second line-like conductor layers 329 and 329b (both the first and second line-like conductor layers will be described later); and a flat plate-like part 312 that is provided between the support parts 311 and 311B and the substrate 2 and covers the main surface 21. The support parts 311 and 311B and the flat plate-like part 312 are formed integrally.

As illustrated in FIG. 2 or FIG. 4, cross-sectional shapes of the support parts 311 and 311B (cross-sectional shapes with respect to extending directions of the first line-like conductor layers 321 and 322 or the second line-like conductor layers 329 and 329b) in the present embodiment are each a shape in which the width becomes narrower toward a direction departing from the substrate 2. Upper surfaces of the support parts 311 (adhesion surfaces at boundaries between the support parts 311 and the first line-like conductor layers 321 and 322) are uneven (irregular) in cross-sectional views, corresponding to uneven shapes of lower surfaces of the first line-like conductor layers 321 and 322 (first adhesion surfaces 33 (which will be described later)). Similarly, upper surfaces of the support parts 311B (adhesion surfaces at boundaries between the support parts 311B and the second line-like conductor layers 329 and 329b) are also uneven in cross-sectional views, corresponding to uneven shapes of lower surfaces of the second line-like conductor layers 329 and 329b (second adhesion surfaces 34 (which will be described later)). Such uneven shapes are formed due to the surface roughness of the first adhesion surfaces 33 of the first line-like conductor layers 321 and 322 or the surface roughness of the second line-like conductor layers 329 and 329b. Similarly, boundaries between the support parts 311 and the first line-like conductor layers 321 and 322 (see FIG. 5) in the cross-sections along the extending directions of the first line-like conductor layers 321 and 322, and boundaries between the support parts 311B and the second line-like conductor layers 329 and 329b in the cross-sections along the extending directions of the second line-like conductor layers 329 and 329b, are also uneven corresponding to the uneven shapes of the first adhesion surfaces 33 and the second adhesion surfaces 34. The surface roughness of the first adhesion surfaces 33 and the second adhesion surfaces 34 will be described later in detail. For easy understanding of the wiring body 3 in the present embodiment, in FIG. 2 and FIG. 4, the uneven shapes of boundaries between the support parts 311 and the first line-like conductor layers 321 and 322 and the uneven shapes of boundaries between the support parts 311B and the second line-like conductor layers 329 and 329b are illustrated in an exaggerated manner.

The flat plate-like part 312 is provided on the entire area of the main surface 21 of the substrate 2 at its approximately uniform height (thickness). The thickness of the flat plate-like part 312 is not particularly limited, but can be set within a range of 5 $\mu$m to 100 $\mu$m. Providing the support parts 311 and 311B on the flat plate-like part 312 allows the adhesion layer 31 to protrude at the support parts 311 and 311B, and the rigidity of the first line-like conductor layers 321 and 322 and the second line-like conductor layers 329 and 329b is improved with the support parts 311 and 311B.

The flat plate-like part 312 may be omitted from the adhesion layer 31 and the adhesion layer 31 may consist only of the support parts 311 and 311B. This may improve the optical transparency of the wiring board 1 as a whole and the touch sensor 10 can have enhanced visibility. The adhesion layer 31 in the present embodiment corresponds to an example of the resin layer of the present invention.

The conductor layer 32 is a layer that functions, for example, as electrodes and lead wirings. The conductor layer 32 may be made of a conductive material (conductive particles) and a binder resin. Examples of the conductive material include a metal material, such as silver, copper, nickel, tin, bismuth, zinc, indium, and palladium; and a carbon-based material, such as graphite, carbon black (furnace black, acetylene black, Ketjen black), carbon nanotube, and carbon nanofiber. Metal salt may also be used as the conductive material. Examples of the metal salt include salts of the above-described metals.

Conductive particles that can be used as the conductive particles included in the conductor layer 32 may have a diameter $\varphi$ of 0.5 $\mu$m to 2 $\mu$m (0.5 $\mu$m$\leq\varphi\leq$2 $\mu$m), for example, in accordance with the widths of conductor patterns to be formed (first line-like conductor layers 321 and 322 and second line-like conductor layers 329 and 329b). From the viewpoint of stabilizing the electric resistance value of the conductor layer 32, it is preferred to use conductive particles having an average diameter $\varphi$ that is not larger than half the width of a conductor pattern to be formed. In an embodiment, it may be preferred to use particles of which the specific surface area as measured by a BET method is 20 m$^2$/g or more, as the conductive particles.

When the conductor layer 32 is required to have a relatively small electric resistance value that is not larger than a certain level, it is preferred to use a meatl material as the conductive material, while when the conductor layer 32 is accepted to have a relatively large electric resistance value that is not smaller than a certain level, a carbon-based material can be used as the conductive material. From the viewpoint of improving the haze and total light reflectance of a mesh film, it is preferred to use a carbon-based material.

In the present embodiment, electrode layers 320 are formed into a net-like shape to give optical transparency. In this case, conductive materials that are excellent in the conductivity but opaque, such as silver, copper, nickel and other metal materials and the above-described carbon-based materials, (opaque metal materials and opaque carbon-based materials) can be used as a constitutional material of the electrode layers 320.

Examples of the binder resin include acrylic resin, polyester resin, epoxy resin, vinyl resin, urethane resin, phenol resin, polyimide resin, silicone resin, and fluorine resin.

The conductor layer 32 as the above may be formed by applying a conductive paste and curing it. Specific examples of such a conductive paste include a conductive paste that is composed by mixing the above-described conductive material and binder resin with water or solvent and various additives. Examples of the solvent contained in the conductive paste include $\alpha$-terpineol, butyl carbitol acetate, butyl carbitol, 1-decanol, butyl cellosolve, diethylene glycol monoethyl ether acetate, and tetradecane. The binder resin may be omitted from the materials which constitute the conductor layer 32.

As illustrated in FIG. 1, the conductor layer 32 in the present embodiment has the electrode layers 320, which extend along the Y-axis direction in FIG. 1, and lead wiring layers 324 that are connected to the electrode layers 320. In the present embodiment, three electrode layers 320 are arranged approximately at regular intervals along the X-axis direction in FIG. 1. The number and arrangement of the electrode layers 320 included in the conductor layer 32 are not particularly limited to the above.

The electrode layers 320 each have a plurality of first line-like conductor layers 321 and 322. As illustrated in FIG. 1, the first line-like conductor layers 321 extend in a linear fashion, and the first line-like conductor layers 322 also extend in a linear fashion. The plurality of first line-like conductor layers 321 is arranged approximately at regular intervals to be located side by side parallel to one another, and the plurality of first line-like conductor layers 322 is also arranged approximately at regular intervals to be located side by side parallel to one another. In the present embodiment, the first line-like conductor layers 321 and the first line-like conductor layers 322 are orthogonal to one another, so that the electrode layers 320 are in a mesh-like shape that has a rectangular lattice shape. The shape of the electrode layers 320 is not particularly limited. For example, the electrode layers 320 may have a net shape, such as of a square, rectangle and rhombus. The net shape of the conductor layer 32 may also be a triangle, such as a regular triangle, isosceles triangle and right triangle, and a quadrangle, such as a parallelogram and trapezoid. The shape of net may also be an n-polygon, such as a hexagon (honeycomb shape), octagon, dodecagon and icosagon, circle, ellipsoid, and star-shape. The electrode layers may not be in a mesh-like shape. Although not particularly illustrated, the electrode layers may each have a frame part that surrounds at least a part of the mesh shape formed by the first line-like conductor layers 321 and 322.

In the present embodiment, the first line-like conductor layers 321 and 322 are arranged to incline by 45° with respect to the extending direction of the electrode layers 320 (Y-axis direction in FIG. 1), but they may also be arranged to incline by another angle (e.g. 30°). Either of the first line-like conductor layers 321 and 322 may be arranged to incline by 90° with respect to the extending direction of the electrode layers 320 (Y-axis direction in FIG. 1).

In an embodiment, the first line-like conductor layers 321 and 322 may extend in a specific form, such as a curved form, horseshoe-like form and zigzag form, and straight line-like portions and other portions, such as curved portions, horseshoe-like portions and zigzag portions, may be mixed. In the present embodiment, the first line-like conductor layers 321 and 322 have approximately the same line width, but they may also have different line widths.

The lead wiring layers 324 in the present embodiment have outer edge parts 324a and wiring parts 324b. The outer edge parts 324a are connected to lower ends in FIG. 1 of the electrode layers 320. As illustrated in the enlarged view in FIG. 1, the outer edge parts 324a each have a mesh shape that is constituted by the second line-like conductor layers 329 and 329b which have a thicker line width than that of the first line-like conductor layers 321 and 322.

In the present embodiment, the second line-like conductor layers 329 and 329b are arranged to incline by 45° with respect to the Y-axis direction in FIG. 1, but they may also be arranged to incline by another angle (e.g. 30°). Either of the second line-like conductor layers 329 and 329b may be arranged to incline by 90° with respect to the Y-axis direction in FIG. 1.

The wiring parts 324b serve to connect the electrode layers 320 to a drive circuit C via terminals 324c and have a mesh shape similar to that of the outer edge parts 324a. In an embodiment, the terminals 324c connected to the wiring parts 324b may also have a mesh shape similar to that of the outer edge parts 324a.

The outer edge parts 324a may be omitted from the lead wiring layers 324. In this case, the electrode layers 320 and the wiring parts 324b are directly connected. The outer edge parts 324a and the wiring parts 324b may not necessarily have a mesh shape. In this case, the outer edge parts 324a may have approximately the same thickness as that of the wiring parts 324b and may each be formed into a line-like solid pattern having a larger width than that of the line-like conductor layers which constitute the wiring parts 324b. When the outer edge parts 324a or the wiring parts 324b are each formed into a solid pattern, the entire area of each outer edge part 324a or each wiring part 324b corresponds to an example of the second line-like conductor layer of the present invention.

In the present embodiment, the electrode layers 320 are formed integrally with the lead wiring layers 324. As used herein, the term "integrally with" refers to a situation in which a member and another member are not separated from each other and they are formed as a one-body structure using the same material (such as using conductive particles of the same particle diameter and the same binder resin). In this regard, the lead wiring layers 324 of the present embodiment each have a single-layer structure composed of a material having the same composition as that of a material that constitutes the electrode layers 320. When the outer edge parts 324a are formed integrally with the wiring parts 324b as in the present embodiment, it is preferred to form the wiring parts 324b also into a net-like shape. When the terminals 324c are formed integrally with the outer edge parts 324a and the wiring parts 324b, it is preferred that the terminals 324c have a net shape.

As illustrated in FIG. 2, a side part 326 of the first line-like conductor layers 321 and 322 and a side part of the support parts 311 of the adhesion layer 31 merge smoothly into each other thereby to form one flat surface. The first line-like conductor layers 321 and 322 have a tapered shape of which the width becomes narrower toward the side (upper side in FIG. 2) departing from the substrate 2, so that the cross-sectional shape of outer surfaces of the first line-like conductor layers 321 and 322 (cross-sectional shape with respect to the extending directions of the first line-like conductor layers 321 and 322) is approximately a trapezoidal shape. The cross-sectional shape of outer surfaces of the first line-like conductor layers 321 and 322 is not particularly limited to the above. For example, the cross-sectional shape of the first line-like conductor layers 321 and 322 may be other shape, such as a square shape, rectangular shape, and triangular shape.

The cross-sectional shape of the first line-like conductor layers 321 of the present embodiment will be described below in detail. As will be understood, the first line-like conductor layers 322 have the same basic structure as that of the first line-like conductor layers 321. FIG. 2 therefore illustrates only a first line-like conductor layer 321, and the corresponding reference numeral for the first line-like conductor layers 322 is parenthesized. Thus, the description for the first line-like conductor layer 321 will be borrowed herein to omit repetitive description.

As illustrated in FIG. 2, the first line-like conductor layer 321 has a first adhesion surface 33, an upper surface 325, and side parts 326 in a cross-section of the first line-like conductor layer 321 in its width direction.

The first adhesion surface 33 is a lower surface in FIG. 2 of the first line-like conductor layer 321 in the present embodiment and has an uneven shape. The upper surface 325 is located at the opposite side to the first adhesion surface 33 in the first line-like conductor layer 321. The upper surface 325 is substantially parallel to the main surface 21 of the substrate 2 (upper surface of the flat plate-like part 312 of the adhesion layer 31).

The upper surface 325 includes a flat part 3251 in the cross-section of the first line-like conductor layer 321 in its width direction. The flat part 3251 is a straight line-like portion (i.e. portion with a considerably large radius of curvature) that exists on the upper surface 325 in the cross-section of the first line-like conductor layer 321 in its width direction, and the flatness of the flat part 3251 is 0.5 μm or less. The flatness is defined by a JIS method (JIS B0621 (1984)).

In the present embodiment, the flatness of the flat part 3251 is obtained using a contactless-type measurement method with laser light. Specifically, a measuring object (the upper surface 325 in the present embodiment) is irradiated with strip-like laser light, and the reflected light is focused on an imaging element (e.g. two-dimensional CMOS) to measure the flatness. The method of calculating the flatness may be a method that includes setting flat surfaces on an object surface so as to pass through three points separate from one another as much as possible and calculating the maximum value of deviation as the flatness (maximum deviation-type flatness). The methods of measuring and calculating the flatness are not limited to the above. For example, the method of measuring the flatness may be a contact-type measurement method using a dial gauge or other appropriate gauge. The method of calculating the flatness may also be a method that includes interposing an object surface between parallel flat surfaces and calculating a value of space generated due to the interposition as the flatness (maximum slope-type flatness).

The flat part 3251 of the present embodiment is formed at approximately the entire area of the upper surface 325. The location at which the flat part 3251 is formed is not particularly limited to the above, and the flat part 3251 may be formed at a part of the upper surface 325. In this case, for example, the flat part may be formed at a region that does not include both ends of the upper surface. When the flat part is formed at a part of the upper surface, the width of the flat part may be at least 1/2 or more of the width of the upper surface.

Each side part 326 is located between the upper surface 325 and the first adhesion surface 33. The side part 326 connects to the upper surface 325 at a first portion 3261 and connects to the first adhesion surface 33 at a second portion 3262. Since the first line-like conductor layer 321 of the present embodiment has a tapered shape of which the width becomes narrower toward the side departing from the adhesion layer 31, the second portion 3262 is located outside the first portion 3261 in the cross-section of the first line-like conductor layer 321 in its width direction. In the cross-section of the first line-like conductor layer 321 in its width direction, the side part 326 of the present embodiment represents a surface that extends on a virtual straight line (not illustrated) passing through the first and second portions 3261 and 3262.

The shape of the side part 326 is not particularly limited to the above. For example, the side part 326 may be in an arc shape that protrudes outward in the cross-section of the first line-like conductor layer 321 in its width direction. In this case, the side part 326 is located outside the virtual straight line passing through the first and second portions 3261 and 3262. In other words, the shape of the side part 326 may preferably be a shape in which a part of the side part 326 does not exist inside the virtual straight line passing through the first and second portions 3261 and 3262, in the cross-section of the first line-like conductor layer 321 in its width direction. For example, when the outer shape of the first line-like conductor layer gradually becomes larger as approaching the resin layer in the cross-section of the first line-like conductor layer in its width direction, if the side part is in an arc shape that protrudes inward (i.e., if the first line-like conductor layer is in a divergent shape with its spread bottom), the light incident to the wiring body may readily undergo diffuse reflection.

The side part 326 of the present embodiment includes a flat part 3263 in the cross-section of the first line-like conductor layer 321 in its width direction. The flat part 3263 is a straight line-like portion (i.e. portion with a considerably large radius of curvature) that exists on the side part 326 in the cross-section of the first line-like conductor layer 321 in its width direction, and the flatness of the flat part 3263 is 0.5 μm or less. The flatness of the flat part 3263 can be measured in the same manner as in the method of measuring the flatness of the flat part 3251. In the present embodiment, the flat part 3263 is formed at approximately the entire area of the side part 326. The shape of the flat part 3263 is not particularly limited to the above, and the flat part 3263 may be formed at a part of the side part 326.

From the viewpoint of suppressing the diffuse reflection of light at the side part 326, an angle $\theta_1$ between the side part 326 and the upper surface 325 is preferably 90° to 170° ($90° \leq \theta_1 \leq 170°$) and more preferably 90° to 120° ($90° \leq \theta_1 \leq 120°$). In the present embodiment, in one first line-like conductor layer 321, the angle between one side part 326 and the upper surface 325 is substantially the same as the angle between the other side part 326 and the upper surface 325. In one first line-like conductor layer 321, the angle between one side part 326 and the upper surface 325 may be different from the angle between the other side part 326 and the upper surface 325.

From the viewpoint of increasing the contact areas between the first line-like conductor layers 321 and 322 and the adhesion layer 31 and tightly fixing the first line-like conductor layers 321 and 322 to the adhesion layer 31, the surface roughness of the first adhesion surface 33 of the first line-like conductor layers 321 and 322 is preferably rougher than the surface roughness of the upper surface 325 in FIG. 2 of the first line-like conductor layers 321 and 322. Since the upper surface 325 includes the flat part 3251 in the present embodiment, the above relative relationship of the surface roughness in the first line-like conductor layer 321 (relationship that the surface roughness of the first adhesion surface 33 is relatively rougher than the surface roughness of the upper surface 325) is established.

Specifically, the surface roughness Ra of the first adhesion surface 33 of the first line-like conductor layer 321 is preferably about 0.1 μm to 3 μm while the surface roughness Ra of the upper surface 325 is pref-

erably about 0.001 $\mu$m to 1.0 $\mu$m. The surface roughness Ra of the first adhesion surface 33 of the first line-like conductor layer 321 is more preferably 0.1 $\mu$m to 0.5 $\mu$m, and the surface roughness Ra of the upper surface 325 is furthermore preferably 0.001 $\mu$m to 0.3 $\mu$m. The ratio of the surface roughness of the upper surface 325 and the surface roughness of the first adhesion surface 33 (ratio of the surface roughness of the upper surface 325 to the surface roughness of the first adhesion surface 33) is preferably 0.01 or more and less than 1 and more preferably 0.1 or more and less than 1. The surface roughness of the upper surface 325 is preferably 1/5 or less of the width (maximum width) of the first line-like conductor layer 321. Such surface roughness can be measured in accordance with a JIS method (JIS B0601 (revised on March 21, 2013)). Measurement of the surface roughness of the upper surface 325 and the first adhesion surface 33 may be performed along the width direction of the first line-like conductor layer 321 and may also be performed along the extending direction of the first line-like conductor layer 321.

As used herein, the "surface roughness Ra" refers to "arithmetic average roughness Ra" as described in the JIS method (JIS B0601 (revised on March 21, 2013)). The "arithmetic average roughness Ra" represents a roughness parameter that is obtained by shutting off long-wavelength components (waviness components) from a profile curve. Separation of the waviness components from the profile curve may be performed on the basis of the measurement condition which is necessary for obtaining a form (such as the size of an object, for example).

In the present embodiment, the side part 326 includes the flat part 3263. The surface roughness of the first adhesion surface 33 is therefore relatively rougher than that of the side part 326. Specifically, the surface roughness Ra of the first adhesion surface 33 of the first line-like conductor layer 321 is preferably 0.1 $\mu$m to 3 $\mu$m while the surface roughness Ra of the side part 326 is preferably 0.001 $\mu$m to 1.0 $\mu$m. The surface roughness Ra of the side part 326 is more preferably 0.001 $\mu$m to 0.3 $\mu$m. Measurement of the surface roughness of the side part 326 may be performed along the width direction of the first line-like conductor layer 321 and may also be performed along the extending direction of the first line-like conductor layer 321.

In the present embodiment, the surface roughness of the first adhesion surface 33 is relatively rougher than the surface roughness of the upper surface 325 and side parts 326 and, therefore, the diffuse reflectance of the wiring body 3 at other surfaces than the first adhesion surface 33 (i.e. at the upper surface 325 and side parts 326) is relatively smaller than the diffuse reflectance of the wiring body 3 at the first adhesion surface 33. From the viewpoint of improving the visibility of the wiring body 3, the ratio of the diffuse reflectance of the wiring body 3 at other surfaces than the first adhesion surface 33 and the diffuse reflectance of the wiring body 3 at the first adhesion surface 33 (ratio of the diffuse reflectance of the wiring body 3 at other surfaces than the first adhesion surface 33 to the diffuse reflectance of the wiring body 3 at the first adhesion surface 33) is preferably 0.1 or more and less than 1 and more preferably 0.3 or more and less than 1.

An example of the shape of a first line-like conductor layer having the above-described relative relationship of the surface roughness between the first adhesion surface and other surfaces than the first adhesion surface will be described with reference to FIG. 3. As illustrated in FIG. 3, in a first line-like conductor layer 321B that is composed of conductive particles M and a binder resin B, a number of the conductive particles M are dispersed in the binder resin B. In a first adhesion surface 33B of the first line-like conductor layer 321B, a part of the conductive particles M protrudes from the binder resin B in the cross-section in the width direction. The first adhesion surface 33B therefore has an uneven shape. On the other hand, in an upper surface 325B and side parts 326B, the binder resin B gets into spaces between the conductive particles M, and the binder resin B covers the conductive particles M. Thus, the upper surface 325B includes a flat part 3251B, and the side parts 326B include flat parts 3263B. In the upper surface 325B and the side parts 326B, the conductive particles M are covered with the binder resin B, so that the electric insulation is improved between adjacent first line-like conductor layers 321B and the occurrence of migration is suppressed.

In the form illustrated in FIG. 3, the first adhesion surface 33B has an uneven shape while the upper surface 325B includes the flat part 3251B. The surface roughness of the first adhesion surface 33B is therefore relatively rougher than the surface roughness of the upper surface 325B. Similarly, in the form illustrated in FIG. 3, the side parts 326B include the flat parts 3263B. The surface roughness of the first adhesion surface 33B is therefore relatively rougher than the surface roughness of the side parts 326B. Forms of the lower surface (first adhesion surface), upper surface, and side parts of the first line-like conductor layer are not particularly limited to the above.

In the present embodiment, as illustrated in FIG. 2, the first line-like conductor layers 321 and 322 which constitute each electrode layer 320 have approximately the same width (maximum width in the cross-sectional views with respect to the extending directions of the first line-like conductor layers 321 and 322) $W_1$. From the viewpoint of improving the visibility of the touch sensor 10, the width $W_1$ of the first line-like conductor layers 321 and 322 is preferably 50 nm to 1000 $\mu$m, more preferably 500 nm to 150 $\mu$m, further preferably 1 $\mu$m to 10 $\mu$m, and furthermore preferably 1 $\mu$m to 5 $\mu$m. The height of the line-like conductor layers 321 and 322 is preferably 50 nm to 3000 $\mu$m, more preferably 500 nm to 450 $\mu$m, and further preferably 500 nm to 10 $\mu$m.

As illustrated in FIG. 4, a side part 328 of the second line-like conductor layers 329 and 329b and a side part of the support parts 311B of the adhesion layer 31 merge smoothly into each other thereby to form one flat surface. The second line-like conductor layers 329 and 329b have a tapered shape of which the width becomes narrower toward the side (upper side in FIG. 4) departing from the substrate 2, so that the cross-sectional shape of outer surfaces of the second line-like conductor layers 329 and 329b (cross-sectional shape with respect to the extending directions of the second line-like conductor layers 329 and 329b) is approximately a trapezoidal shape. The cross-sectional shape of outer surfaces of the second line-like conductor layers 329 and 329b is not particularly limited to the above. For example, the cross-sectional shape of the second line-like conductor layers 329 and 329b may be other shape, such as a square shape, rectangular shape, and triangular shape.

The cross-sectional shape of the second line-like conductor layers 329 of the present embodiment will be described below in detail. As will be understood, the second line-like conductor layers 329b have the same basic structure as that of the second line-like conductor layers 329. FIG. 4 therefore illustrates only a second line-like conductor layer 329, and the corresponding reference numeral for the second line-like conductor layers 329b is parenthesized. Thus, the description for the second line-like conductor layer 329 will be borrowed herein to omit repetitive description.

As illustrated in FIG. 4, the second line-like conductor layer 329 has a second adhesion surface 34, an upper surface 327, and side parts 328 in a cross-section of the second line-like conductor layer 329 in its width direction.

The second adhesion surface 34 is a lower surface of the second line-like conductor layers 329 and 329b and has an uneven shape. The upper surface 327 is located at the opposite side to the second adhesion surface 34 in the second line-like conductor layer 329. The upper surface 327 is substantially parallel to the main surface 21 of the substrate 2 (upper surface of the flat plate-like part 312 of the adhesion layer 31).

The upper surface 327 includes a flat part 3271 in the cross-section of the second line-like conductor layer 329 in its width direction. The flat part 3271 is a straight line-like portion (i.e. portion with a considerably large radius of curvature) that exists on the upper surface 327 in the cross-section of the second line-like conductor layer 329 in its width direction, and the flatness of the flat part 3251 is 0.5 $\mu$m or less. The flatness of the flat part 3271 can be measured in the same manner as in the method of measuring the flatness of the flat part 3251.

The flat part 3271 of the present embodiment is formed at approximately the entire area of the upper surface 327. The location at which the flat part 3271 is formed is not particularly limited to the above. and the flat part 3271 may be formed at a part of the upper surface 327. In this case, for example, the flat part may be formed at a region that does not include both ends of the upper surface. When the flat part is formed at a part of the upper surface, the width of the flat part may be at least 1/2 or more of the width of the upper surface.

Each side part 328 is located between the upper surface 327 and the second adhesion surface 34. The side part 328 connects to the upper surface 327 at a first portion 3281 and connects to the second adhesion surface 34 at a second portion 3282. Since the second line-like conductor layer 329 of the present embodiment has a tapered shape of which the width becomes narrower toward the side departing from the substrate 2, the second portion 3282 is located outside the first portion 3281 in the cross-section of the second line-like conductor layer 329 in its width direction. In the cross-section of the second line-like conductor layer 329 in its width direction, the side part 328 of the present embodiment represents a surface that extends on a virtual straight line (not illustrated) passing through the first and second portions 3281 and 3282.

The shape of the side part 328 is not particularly limited to the above. For example, the side part 328 may be in an arc shape that protrudes outward in the cross-section of the second line-like conductor layer 329 in its width direction. In this case, the side part 328 is located outside the virtual straight line passing through the first and second portions 3281 and 3282. In other words, the shape of the side part 328 may preferably be a shape in which a part of the side part 328 does not exist inside the virtual straight line passing through the first and second portions 3281 and 3282 in the cross-section of the second line-like conductor layer 329 in its width direction. For example, when the outer shape of the second line-like conductor layer gradually becomes larger as approaching the resin layer in the cross-section of the second line-like conductor layer in its width direction, the side part is preferably not in an arc shape that protrudes inward (i.e., the second line-like conductor layer is preferably not in a divergent shape with its spread bottom).

The side part 328 of the present embodiment includes a flat part 3283 in the cross-section of the second line-like conductor layer 329 in its width direction. The flat part 3283 is a straight line-like portion (i.e. portion with a considerably large radius of curvature) that exists on the side part 328 in the cross-section of the second line-like conductor layer 329 in its width direction, and the flatness of the flat part 3283 is 0.5 $\mu$m or less. The flatness of the flat part 3283 can be measured in the same manner as in the method of measuring the flatness of the flat part 3251. In the present embodiment, the flat part 3283 is formed at approximately the entire area of the side part 328. The shape of the flat part 3283 is not particularly limited to the above, and the flat part 3283 may be formed at a part of the side part 328.

An angle $\theta_2$ between the side part 328 and the upper surface 327 is preferably 90° to 170° ($90° \leq \theta_2 \leq 170°$) and more preferably 90° to 120° ($90° \leq \theta_2 \leq 120°$). In the present embodiment, the angle between one side part 328 and the upper surface 327 is substantially the same as the angle between the other side part 328 and the upper surface 327 in one second line-like conductor layer 329. In one second line-like conductor layer 329, the angle between one side part 328 and the upper surface 327 may be different from the angle between the other side part 328 and the upper surface 327.

From the viewpoint of increasing the contact areas between the second line-like conductor layers 329 and 329b and the adhesion layer 31 and tightly fixing the second line-like conductor layers 329 and 329b to the adhesion layer 31, in the present embodiment, the surface roughness of the second adhesion surface 34 in FIG. 4 of the second line-like conductor layers 329 and 329b is preferably rougher than the surface roughness of the upper surface 327 in FIG. 4 of the second line-like conductor layers 329 and 329b. Since the upper surface 327 includes the flat part 3271 in the present embodiment, the above relative relationship of the surface roughness in the second line-like conductor layer 329 (relationship that the surface roughness of the second adhesion surface 34 is relatively rougher than the surface roughness of the upper surface 327) is established.

Specifically, the surface roughness Ra of the second adhesion surface 34 of the second line-like conductor layer 329 is preferably about 0.1 $\mu$m to 3 $\mu$m while the surface roughness Ra of the upper surface 327 is preferably about 0.001 $\mu$m to 1.0 $\mu$m. The surface roughness Ra of the second adhesion surface 34 of the second line-like conductor layer 329 is more preferably 0.1 $\mu$m to 0.5 $\mu$m, and the surface roughness Ra of the upper surface 327 is furthermore preferably 0.001 $\mu$m to 0.3 $\mu$m. The ratio of the surface roughness of the upper surface 327 and the surface roughness of the second adhesion surface 34 (ratio of the surface roughness of the upper surface 327 to the surface roughness of the second adhesion surface 34) is preferably 0.01 or more and less than 1 and more preferably 0.1 or more and less than 1. The surface roughness of the upper surface 327 is preferably 1/5 or less of the width (maximum width) of the second line-like conductor layer 329. Such surface roughness can be measured in accordance with a JIS method (JIS B0601 (revised on March 21, 2013)). Measurement of the surface roughness of the upper surface 327 and the second adhesion surface 34 may be performed along the width direction of the second line-like conductor layer 329 and may also be performed along the extending direction of the second line-like conductor layer 329.

In the present embodiment, the side part 328 includes the flat part 3283. The surface roughness of the second adhesion surface 34 is therefore relatively rougher than that of the side part 328. Specifically, the surface roughness Ra of the second adhesion surface 34 of the second line-like conductor layer 329 is preferably 0.1 $\mu$m to 3 $\mu$m while the surface roughness Ra of the side part 328 is preferably 0.001 $\mu$m to 1.0 $\mu$m. In an embodiment, the surface roughness Ra of the side part 328 is more preferably 0.001 $\mu$m to 0.3 $\mu$m. Measurement of the sur-

face roughness of the side part 328 may be performed along the width direction of the second line-like conductor layer 329 and may also be performed along the extending direction of the second line-like conductor layer 329.

A similar shape to that of the first line-like conductor layer 321B illustrated in FIG. 3 can be exemplified as an example of the shape of a second line-like conductor layer that has the above-described relative relationship of the surface roughness between the second adhesion surface and other surfaces than the second adhesion surface. In the second adhesion surface of the second line-like conductor layer, a part of the conductive particles protrudes from the binder resin in the cross-section of the second line-like conductor layer in its width direction. On the other hand, in the upper surface and side parts of the second line-like conductor layer, the binder resin gets into spaces between the conductive particles in the cross-section of the second line-like conductor layer in its width direction, and the binder resin covers the conductive particles. In this case, the second adhesion surface has an uneven shape and the upper surface includes a flat part. The surface roughness of the second adhesion surface of the second line-like conductor layer is therefore relatively rougher than the surface roughness of the upper surface of the second line-like conductor layer. In this example, the side parts of the second line-like conductor layer also include flat parts. The surface roughness of the second adhesion surface of the second line-like conductor layer is therefore relatively rougher than the surface roughness of the side parts of the second line-like conductor layer. Forms of the lower surface (second adhesion surface), upper surface, and side parts of the second line-like conductor layer are not limited to the above.

In the present embodiment, as illustrated in FIG. 4, the second line-like conductor layers 329 and 329b which constitute each lead wiring layer 324 have approximately the same width (maximum width in the cross-sectional views with respect to the extending directions of the second line-like conductor layers 329 and 329b) $W_2$. The width $W_2$ of the second line-like conductor layers 329 and 329b is preferably 1 $\mu$m to 500 $\mu$m, and more preferably 3 $\mu$m to 100 $\mu$m and furthermore preferably 5 $\mu$m to 30 $\mu$m from the viewpoint of improving the durability of the wiring body 3 while suppressing the increase in the electric resistance value of the lead wiring layers 324. The height of the second line-like conductor layers 329 and 329b is preferably 3 $\mu$m to 20 $\mu$m.

In the present embodiment, as illustrated in FIG. 4, a surface obtained by averaging the uneven shape of the lower surface of the second line-like conductor layers 329 and 329b is moderately curved toward the direction departing from the substrate 2 as compared with a surface obtained by averaging the uneven shape of the lower surface of the first line-like conductor layers 321 and 322 (see FIG. 2).

In the present embodiment, therefore, Expression (7) below is satisfied:

$$R_1 < R_2 \ldots (7).$$

In the above Expression (7), $R_1$ is a curvature of the surface (first adhesion surface 33) obtained by averaging the lower surface of the first line-like conductor layers 321 and 322, and $R_2$ is a curvature of the surface (second adhesion surface 34) obtained by averaging the lower surface of the second line-like conductor layers 329 and 329b. When the above Expression (7) is satisfied, contact areas between the second line-like conductor layers 329 and 329b and the support parts 311B of the adhesion layer 31 can relatively increase to improve the interfacial adhesion between the second line-like conductor layers 329 and 329b and the support parts 311B.

In the wiring body 3 of the present embodiment, Expressions (8) to (11) below are satisfied:

$$T_1 < T_2 \ldots (8),$$

$$H_1 < H_2 \ldots (9),$$

$$W_1 < W_2 \ldots (10),$$

and

$$S_1 < S_2 \ldots (11).$$

In the above Expression (8), $T_1$ is a maximum thickness (average maximum thickness in cross-sectional views across the entire plane) of the first line-like conductor layers 321 and 322, and $T_2$ is a maximum thickness (average maximum thickness in cross-sectional views across the entire plane) of the second line-like conductor layers 329 and 329b. In the above Expression (9), $H_1$ is a height (average height in cross-sectional views across the entire plane) in the cross-sectional view from the lower surface of the adhesion layer 31 to the upper surface of the first line-like conductor layers 321 and 322, and $H_2$ is a height (average height in cross-sectional views across the entire plane) in the cross-sectional view from the lower surface of the adhesion layer 31 to the upper surface of the second line-like conductor layers 329 and 329b. In the above Expression (10), $W_1$ is a maximum width (average maximum width in cross-sectional views across the entire plane) of the first line-like conductor layers 321 and 322, and $W_2$ is a maximum width (average maximum width in cross-sectional views across the entire plane) of the second line-like conductor layers 329 and 329b. In the above Expression (11), $S_1$ is a thickness (average maximum thickness in cross-sectional views across the entire plane) in the cross-sectional view of the adhesion layer 31 at adhesion portions (adhesion surfaces) with the first line-like conductor layers 321 and 322, and $S_2$ is a thickness (average maximum thickness in cross-sectional views across the entire plane) in the cross-sectional view of the adhesion layer 31 at adhesion portions (adhesion surfaces) with the second line-like conductor layers 329 and 329b.

As used herein, the "average maximum thickness in cross-sectional views across the entire plane" refers to a value obtained through sampling a plurality of cross-sections along the width direction of each conductor line across the entire extending direction of the conductor line and averaging maximum thicknesses obtained for respective cross-sections. Similarly, the "average height in cross-sectional views across the entire plane" refers to a value obtained through sampling a plurality of cross-sections along the width direction of each conductor line across the entire extending direction of the conductor line and averaging heights obtained for respective cross-sections, and the "average maximum width in cross-sectional views across the entire plane" refers to a value obtained through sampling a plurality of cross-sections along the width direction of each conductor line across the entire extending direction of the conductor line and averaging maximum widths obtained for respective cross-sections. Examples of the above conductor line include the first line-like conductor layers 321 and 322 and the second line-like conductor layers 329 and 329b. The above conductor line may be appropriately selected in accordance with the parameter to be obtained.

The wiring body 3 may not necessarily satisfy the above Expressions (9) to (11), but in consideration of an effect of suppressing the increase in the electric resistance value of the lead wiring layers 324, an effect of suppressing breakage of the lead wiring layers 324, and other effects, it is preferred for the wiring body 3 to satisfy Expressions (9) to (11).

In the present embodiment, an aspect ratio ($W_2/T_2$) of the second line-like conductor layers 329 and 329b in the cross-sectional view is one or more. That is, the second line-like conductor layers 329 and 329b are each in a horizontally-long shape along the main surface 21 of the substrate 2 in the cross-sectional views.

In the present embodiment, provided that strain and other deformation of the entire wiring substrate 1 are negligible, the upper surfaces of the second line-like conductor layers 329 and 329b are relatively higher than the upper surfaces of the first line-like conductor layers 321 and 322. Thus, the upper surfaces of the lead wiring layers 324 relatively protrude with respect to the upper surfaces of the electrode layers 320. Average surfaces of the lower surfaces (second adhesion surfaces 34) of the second line-like conductor layers 329 and 329b are also relatively higher than average surfaces of the lower surfaces (first adhesion surfaces 33) of the first line-like conductor layers 321 and 322.

Connection portions between the electrode layers 320 and the lead wiring layers 324 (specifically, outer edge parts 324a) will be described in detail with reference to FIG. 5.

As illustrated in FIG. 5, in each connection portion between an electrode layer 320 and a lead wiring layer 324, a first line-like conductor layer 322 that constitutes the electrode layer 320 connects to a second line-like conductor layer 329c that constitutes the lead wiring layer 324. The second line-like conductor layer 329c extends along the boundary between the electrode layer 320 and the lead wiring layer 324. The second line-like conductor layer 329c has the same cross-sectional shape as that of the above-described second line-like conductor layer 329b in the cross-section of the second line-like conductor layer 329c in its width direction. Detailed description of the cross-sectional shape of the second line-like conductor layer 329c will be omitted and the description of the above-described second line-like conductor layer 329b will be borrowed herein.

In the connection portion between the electrode layer 320 and the lead wiring layer 324, the upper surface 325 of the first line-like conductor layer 322 and the upper surface 327 of the second line-like conductor layer 329c are connected to each other. In the connection portion between the electrode layer 320 and the lead wiring layer 324, the first adhesion surface 33 of the first line-like conductor layer 322 and the second adhesion surface 34 of the second line-like conductor layer 329c are connected to each other.

In the present embodiment, the second line-like conductor layer 329c has side parts that incline so as to approach the center of the second line-like conductor layer 329c as departing from the substrate 2 in the cross-section of the second line-like conductor layer 329c in its width direction. The conductor portion is therefore raised gradually from the upper surface 325 to the upper surface 327. Thus, in the connection portion between the electrode layer 320 and the lead wiring layer 324, the thickness of the conductor portion continuously increases toward the second line-like conductor layer 329c from the first line-like conductor layer 322. If the thickness of the conductor portion increases sharply in the connection portion between the electrode layer 320 and the lead wiring layer 324, stress may possibly concentrate in the connection portion to readily cause breakage.

The upper surface 325 of the first line-like conductor layer 322 is preferably located at the side departing from the substrate 2 (adhesion layer 31) in the Z-direction as compared with at least a part of the second adhesion surface 34 of the second line-like conductor layer 329c. In this case, the conduction between the first line-like conductor layer 322 and the second line-like conductor layer 329c can be more steadily obtained because the thickness of the connection portion between the electrode layer 320 and the lead wiring layer 324 can be ensured. In the present embodiment, the upper surface 325 of the first line-like conductor layer 322 is located at the side closer to the substrate 2 in the Z-direction than the most protruding portion of the second adhesion surface 34 of the second line-like conductor layer 329c. In this case, the visibility of the wiring body 3 is improved because the height of the first line-like conductor layer 322 is controlled and the diffuse reflection of light incident to the wiring body 3 is suppressed.

The relative positional relationship between the upper surface 325 and the second adhesion surface 34 is not particularly limited to the above. For example, as illustrated in FIG. 6, the upper surface 325 of a first line-like conductor layer 322B may be located at the side departing from the substrate 2 in the Z-direction as compared with the most protruding portion of the second adhesion surface 34 of the second line-like conductor layer 329c. In this case, the thickness of the conductor portion can be large in the connection portion between an electrode layer 320B and the lead wiring layer 324. This positional relationship is therefore preferred from the viewpoint of reducing the electric resistance value of the connection portion. Moreover, this positional relationship is preferred from the viewpoint that the first line-like conductor layer 322B and the second line-like conductor layer 329c can be tightly connected to each other.

The touch sensor 10 in the present embodiment includes a second wiring body (not illustrated) that is provided above the wiring body 3 via a resin layer for ensuring insulation from the electrode layers 320. The second wiring body is arranged such that the direction in which electrode layers of the second wiring body extend is orthogonal to the direction in which the electrode layers 320 of the wiring body 3 extend. The electrode layers 320 of the first wiring body and the electrode layers of the second wiring body are connected to the drive circuit C. The drive circuit C operates to periodically apply a predetermined voltage between the electrode layers 320 of the first wiring body and the electrode layers of the second wiring body and determine a contact position with the finger of an operator on the touch sensor 10 on the basis of the change in the capacitance at each intersection of two electrode layer. Two wiring substrates 1 may be stacked on each other to constitute a touch sensor such that the extending directions of the electrode layers 320 are orthogonal to each other.

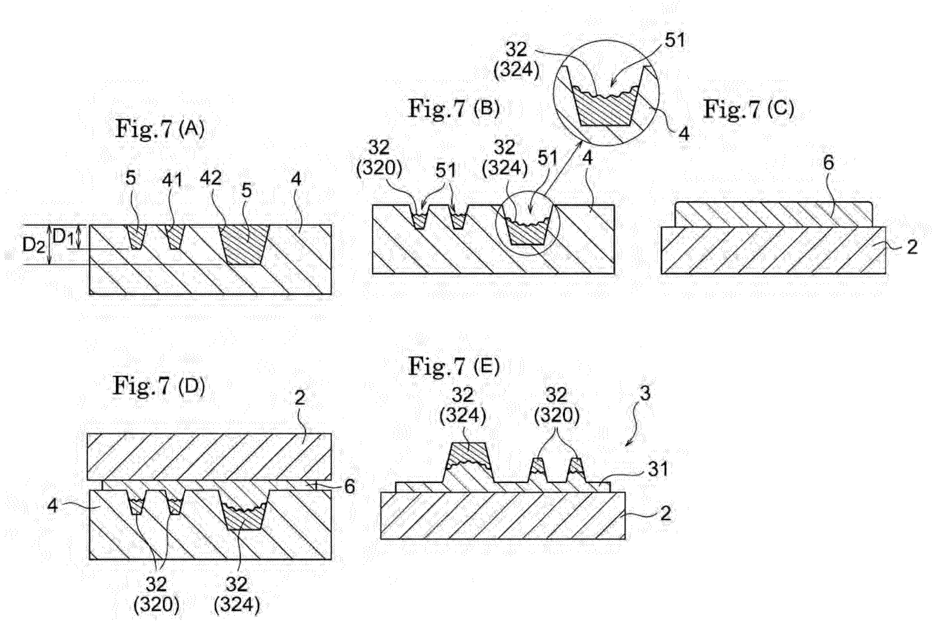

A production method for the wiring body 3 in the present embodiment will then be described. FIG. 7(A) to FIG. 7(E) are cross-sectional views (schematic views) for describing the production method for the wiring body 3 in the present embodiment.

First, a recessed plate 4 is prepared as illustrated in Fig. 7(A). The recessed plate 4 is formed with first recesses 41 and second recesses 42. The first recesses 41 have a shape corresponding to the shape of the first line-like conductor layers 321 and 322 which constitute the electrode layers 320. The second recesses 42 have a shape corresponding to the shape of the second line-like conductor layers 329 and 329b which constitute the lead wiring layers 324.

In the present embodiment, Expression (12) below is satisfied:

$$D_1 < D_2 \ldots (12).$$

In the above Expression (12), $D_1$ is a depth of the first recesses 41, and $D_2$ is a depth of the second recesses 42.

Examples of a material of which the recessed plate 4 is made include nickel, silicon, glasses such as silicon dioxide, organic silicas, glassy carbon, thermoplastic resin, and photo-curable resin. The width of the first recesses 41 is preferably 50 nm to 1000 $\mu$m, more preferably 500 nm to 150 $\mu$m, further preferably 1 $\mu$m to 10 $\mu$m, and furthermore preferably 1 $\mu$m to 5 $\mu$m. The depth of the first recesses 41 is preferably 50 nm to 3000 $\mu$m, more preferably 500 nm to 450 $\mu$m, and further preferably 500 nm to 10 $\mu$m. The width of the second recesses 42 is preferably 1 $\mu$m to 500 $\mu$m, more preferably 3 $\mu$m to 100 $\mu$m, and further preferably 5 $\mu$m to 30 $\mu$m. The depth of the second recesses 42 is preferably 3 $\mu$m to 20 $\mu$m. In the present embodiment, the cross-sectional shapes of the first and second recesses 41 and 42 are each formed in a tapered shape of which the width becomes narrower toward the bottom part.

To improve releasability, it is preferred for the surfaces of the first and second recesses 41 and 42 to be preliminarily formed with release layers (not illustrated) made of an appropriate material, such as a black lead-based material, silicone-based material, fluorine-based material, ceramic-based material, and aluminum-based material.

The first and second recesses 41 and 42 of the above recessed plate 4 are filled with a conductive material 5 (first step). The above-described conductive paste may be used as such a conductive material 5.

Examples of a method of filling the first and second recesses 41 and 42 of the recessed plate 4 with the conductive material 5 include a dispensing method, ink-jet method, and screen printing method. Another possible method may include coating with a conductive material, such as by a slit-coating method, bar-coating method, blade-coating method, dip-coating method, spray-coating method and spin-coating method, and then wiping, scratching, suctioning, peeling, washing, or blowing away the conductive material applied to other parts than the first and second recesses 41 and 42. An appropriate method can be selected in accordance with the composition or the like of the conductive material and the shape or the like of the recessed plate.

Then, as illustrated in FIG. 7(B), the conductive material 5 with which the first and second recesses 41 and 42 of the recessed plate 4 are filled is heated to form conductive patterns that constitute the conductor layer 32 (second step). A heating condition for the conductive material 5 can be appropriately set in accordance with the composition or the like of the conductive material. Due to this heat treatment, the conductive material 5 undergoes volume contraction and is formed with a curved shape at a surface 51 in the second recesses 42. Surfaces 51 of the conductive material 5 are also formed with slightly uneven shapes. During this treatment, outer surfaces of the conductive material 5 other than the upper surfaces are formed into shapes that follow the first and second recesses 41 and 42. The treatment method for the conductive material 5 is not limited to heating. The conductive material 5 may be irradiated with energy rays, such as infrared rays, ultraviolet rays and laser light, or may be simply dried. Two or more treatment methods as the above may be employed in combination. The existence of uneven shapes and curved shapes on the surfaces 51 increases contact areas between the conductor layer 32 and the adhesion layer 31, and the conductor layer 32 can be more tightly fixed to the adhesion layer 31.

Subsequently, as illustrated in FIG. 7(C), preparation is performed such that the substrate 2 is approximately uniformly coated with an adhesive material 6 for forming the adhesion layer 31. A material that constitutes the adhesion layer 31 may be used as the adhesive material 6. Examples of a method of coating the substrate 2 with the adhesive material 6 include a screen printing method, spray-coating method, bar-coating method, dip method, and ink-jet method.

The method of forming the adhesion layer 31 is not limited to the above. For example, the adhesion layer 31 may be formed through coating the recessed plate 4 formed with the conductor layer 32 (recessed plate 4 in the state illustrated in FIG. 7(B)) with the adhesive material 6, disposing the substrate 2 on the adhesive material 6, and thereafter performing at least one of heating, drying and irradiation with energy rays for the adhesive material 6 in a state in which the substrate 2 is disposed above and pressed against the recessed plate 4. When a thermoplastic material is used as the adhesive material 6, the adhesion layer 31 can be formed by melting the thermoplastic material, such as by heating, and then cooling it.

Then, as illustrated in FIG. 7(D), the substrate 2 and the adhesive material 6 are disposed on the recessed plate 4 so that the adhesive material 6 gets into the first and second recesses 41 and 42 of the recessed plate 4, and the substrate 2 is pressed against the recessed plate 4 to form the adhesion layer 31 (third step). Examples of a method of forming the adhesion layer 31 include irradiation with energy rays, such as ultraviolet rays, infrared rays and laser light, heating, heating and cooling, and drying. Thus, the adhesion layer 31 is formed and adheres to the substrate 2 and the conductor layer 32 to fix them to each other.

Subsequently, as illustrated in FIG. 7(E), the substrate 2, the adhesion layer 31, and the conductor layer 32 are released from the recessed plate 4, and the wiring body 3 can thus be obtained (fourth step).

Actions of the wiring body 3 obtained through the above-described production method will then be described.

In the wiring body 3 of the present embodiment, the electrode layers 320 provided on the adhesion layer 31 and the lead wiring layers 324 formed integrally with the electrode layers 320 satisfy the above Expressions (7) and (8), and cross-sectional areas of the lead wiring layers 324 can thereby be increased as compared with lead wiring layers that have the same thickness as that of the electrode layers 320. This can suppress increase in the electric resistance value of the lead wiring layers 324 and improve the detection sensitivity of the touch sensor 10. In the present embodiment, the wiring body 3 satisfies the above Expression (10), and the cross-sectional areas of the lead wiring layers 324 can thereby be more increased. The above effects can therefore be further improved.

The lead wiring layers 324 of the present embodiment each have a single-layer structure made of a material having the same composition as that of a material of which the electrode layers 320 is made. This allows current to uniformly flow in the entire cross-section of each lead wiring layer 324 in its width direction, and it is thus possible to suppress increase in the electric resistance value of the lead wiring layers 324 and further improve the detection sensitivity of the touch sensor 10. If, hypothetically, each lead wiring layer has a multilayer-structure made of materials having different compositions, the current is likely to flow in a layer of which the electric resistance value is relatively small. In this case, the current concentrates in the layer of which the electric resistance value is relatively small, and a layer of which the electric resistance value is relatively large cannot sufficiently contribute to the conduction of the lead wiring layer. The actual electric resistance value will therefore be larger than an electric resistance value that is expected from the cross-sectional area of the lead wiring layer. In addition, if the lead wiring layer has a multilayer-structure, contact resistance caused between different layers affects the current flow to disturb the conduction of the lead wiring layer.

In the present embodiment, the electrode layers 320 are formed into a net-like shape and formed integrally with the lead wiring layers 324. In this case, an opaque conductive material excellent in the conductivity can be employed as the material of which the electrode layers 320 is made. When a material having the same composition as that of the material of which the electrode layers 320 is made is employed as a material of which the lead wiring layers 324 is made, the electric resistance value can be suppressed from increasing also in the lead wiring layers 324. This can further improve the detection sensitivity of the touch sensor 10.

The wiring body 3 in the present embodiment satisfies the above Expression (9). In this case, the height $H_2$ from the lower surface of the adhesion layer 31 to the upper surfaces of the second line-like conductor layers 329 and 329b is larger than the height $H_1$ from the lower surface of the adhesion layer 31 to the upper surfaces of the first line-like conductor layers 321 and 322. The delamination strength between the lead wiring layers 324 and the adhesion layer 31 can thereby be improved as compared with the delamination strength between the electrode layers 320 and the adhesion layer 31.

This can suppress breakage of the lead wiring layers 324 due to delamination of the lead wiring layers 324 from the adhesion layer 31. In the present embodiment, the above Expression (7) is satisfied and, therefore, the strength of the adhesion layer 31 at portions provided with the lead wiring layers 324 can be enhanced as compared with the strength of the adhesion layer 31 at portions provided with the electrode layers 320, thereby to further improve the above effect. Moreover, in the present embodiment, the above Expression (11) is satisfied and, therefore, the contact areas between the lead wiring layers 324 and the adhesion layer 31 can be increased as compared with the contact areas between the electrode layers 320 and the adhesion layer 31, thereby to furthermore improve the above effect.

In the present embodiment, the upper surfaces 325 of the first line-like conductor layers 322 are located at the side departing from the substrate 2 in the Z-direction as compared with at least a part of the second adhesion surfaces 34 of the second line-like conductor layers 329c. In this case, the conduction between the first line-like conductor layers 322 and the second line-like conductor layers 329c can be more steadily obtained, because the thickness of the connection portions between the electrode layers 320 and the lead wiring layers 324 can be ensured.

In the present embodiment, in the connection portions between the electrode layers 320 and the lead wiring layers 324, the first line-like conductor layers 322 connect to the second line-like conductor layers 329c, and the thickness of the conductor portions continuously increases toward the second line-like conductor layers 329c from the first line-like conductor layers 322. This can suppress the concentration of stress in the connection portions between the electrode layers 320 and the lead wiring layers 324, so that the first line-like conductor layers 322 and the second line-like conductor layers 329c are less likely to break.

If, in the recessed plate 4, the depth of the second recesses for forming the lead wiring layers is approximately the same as the depth of the first recesses for forming the electrode layers when the width of the second line-like conductor layers which constitute the lead wiring layers is made larger than the width of the first line-like conductor layers which constitute the electrode layers, filling failure may occur in the recesses which are to be filled with the conductive material, for example, using a doctor blade or the like. That is, during the filling with the conductive material, the end edge of such a doctor blade comes close to or comes into contact with bottom parts of the second recesses having a wider width, so that the second recesses may not be sufficiently filled with the conductive material.

In contrast to this, in the production method for the wiring body 3 in the present embodiment, the first and second recesses 41 and 42 of the recessed plate 4 satisfy the above Expression (12), that is, the depth $D_2$ of the second recesses 42 is larger than the depth $D_1$ of the first recesses 41. This can suppress the occurrence of filling failure when the second recesses 42 are filled with the conductive material.

In the wiring body 3 of the present embodiment, attention is also focused on the relative relationship of the surface roughness (i.e. the roughness parameter obtained by shutting off the waviness components) between the first adhesion surface 33 of each first line-like conductor layer 321 and other surfaces than the first adhesion surface 33 (surfaces including the upper surface 325 and the side parts 326) in the cross-section of the first line-like conductor layer 321 in its width direction, and the surface roughness Ra of the first adhesion surface 33 is relatively rougher than the surface roughness Ra of the other surfaces. This can suppress the diffuse reflection of incident light from external while allowing the adhesion layer 31 to tightly adhere to the first line-like conductor layer 321. In particular, when the width of the first line-like conductor layer 321 is 1 $\mu$m to 5 $\mu$m, a remarkable effect can be obtained that the relative relationship of the surface roughness between the first adhesion surface 33 and the other surfaces can satisfy the above-described relationship thereby to suppress the diffuse reflection of incident light from external while allowing the adhesion layer 31 to tightly adhere to the first line-like conductor layer 321.

In the present embodiment, the side parts 326 each extend so as to coincide with the virtual line passing through the first and second portions 3261 and 3262. In this case, each side part is in a shape in which a part of the side part does not exist inside the virtual straight line passing through the first and second portions in the cross-section of the first line-like conductor layer 321 in its width direction, and the diffuse reflection of light incident from outside the wiring body 3 is therefore suppressed. This can further improve the visibility of the wiring body 3.

In the present embodiment, the surface roughness Ra of the first adhesion surface 33 is relatively rougher than the surface roughness Ra of other surfaces than the first adhesion surface 33 (surfaces including the upper surface 325 and the side parts 326), and thereby the diffuse reflectance of the wiring body 3 at the other surfaces is relatively smaller than the diffuse reflectance of the wiring body 3 at the first adhesion surface 33. Here, when the diffuse reflectance of the wiring body 3 is small, the first line-like conductor layer 321 can be avoided from being reflected to be white, and the contrast degradation can be suppressed in a region in which the first line-like conductor layer 321 is visible. It is thus possible to further improve the visibility of the wiring body 3 of the present embodiment.

The basis structure of the first line-like conductor layers 322 and the second line-like conductor layers 329 and 329b is the same as that of the first line-like conductor layers 321. Accordingly, the wiring body 3 includes the first line-like conductor layers 322 and the second line-like conductor layers 329 and 329b and can thereby further obtain the above-described actions and effects.

Embodiments heretofore explained are described to facilitate understanding of the present invention and are not described to limit the present invention. It is therefore intended that the elements disclosed in the above embodiments include all design changes and equivalents to fall within the technical scope of the present invention.

For example, the above-described touch sensor 10 of the present embodiment is a projected capacitance-type touch sensor that uses two wiring bodies, but the present invention is not limited to this and can also be applied to a surface capacitance-type (capacitance coupling-type) touch sensor.

Moreover, a mixture of a metal material and a carbon-based material may be used as the conductive material for the conductor layer 32. In this case, in an example of the first line-like conductor layer 321, for example, the carbon-based material may be disposed at the upper surface 325 side of the first line-like conductor layer 321 and the metal material may be disposed at the first adhesion surface 33 side. Conversely, the metal material may be disposed at the upper surface 325 side of the first line-like conductor layer 321 and the carbon-based material may be disposed at the first adhesion surface 33 side.

In the above-described embodiments, the wiring body has been described as being used in a touch sensor, but the use of the wiring body is not particularly limited to this. For example, the wiring body may be used as a heater by flowing current through the wiring body to generate heat, such as by resistance heating. In this case, it is preferred to use a carbon-based material having a relatively high electric resistance value as the conductive material of the conductor layer. In an embodiment, the wiring body may be used as an electromagnetic shield by grounding a part of the conductor part of the wiring body. In an embodiment, the wiring body may be used as an antenna.

The adhesion layer 31 may be omitted from the above-described embodiments and the conductor layer 32 may be provided directly on the substrate 2. The substrate 2 may also be omitted from the above-described embodiments and the resin layer described as the adhesion layer 31 may be used as a base material.

[Description of Reference Numerals]

10 Touch sensor

1 Wiring substrate
2 Substrate
21 Main surface

3 Wiring body
31 Adhesion layer (Resin layer)
311, 311B Support part
312 Flat plate-like part
32 Conductor layer
320 Electrode layer
321, 322 First line-like conductor layer
33 First adhesion surface
325 Upper surface
3251 Flat part
326 Side part
3261 First portion
3262 Second portion
3263 Flat part
324 Lead wiring layer
329, 329b Second line-like conductor layer
34 Second adhesion surface
327 Upper surface
3271 Flat part
328 Side part
3281 First portion
3282 Second portion
3283 Flat part
4 Recessed plate

41    First recess
42 Second recess

5    Conductive material
51 Surface

6    Adhesive material

**Claims**

1.  A wiring body comprising:

    a resin layer;
    an electrode layer provided on a surface of the resin layer at one side and having at least one first line-like conductor layer; and
    a lead wiring layer provided on the surface of the resin layer at the one side and having at least one second line-like conductor layer, the at least one second line-like conductor layer being formed integrally with the electrode layer, wherein
    the lead wiring layer has a single-layer structure made of a material having same composition as that of a material of which the electrode layer is made,
    a following Expression (1) is satisfied:

$$T_1 < T_2 \ \ldots (1)$$

where $T_1$ is a thickness of the first line-like conductor layer, and $T_2$ is a thickness of the second line-like conductor layer.

2.  The wiring body according to claim 1, wherein a following Expression (2) is satisfied:

$$H_1 < H_2 \ \ldots (2)$$

where $H_1$ is a height from a surface of the resin layer at other side to a surface of the first line-like conductor layer at the one side, and $H_2$ is a height from the surface of the resin layer at the other side to a surface of the second line-like conductor layer at the one side.

3.  The wiring body according to claim 1 or 2, wherein an aspect ratio (width/thickness) of the second line-like conductor layer in its cross-sectional view is one or more.

4.  The wiring body according to any one of claims 1 to 3, wherein a following Expression (3) is satisfied:

$$W_1 < W_2 \ \ldots (3)$$

where $W_1$ is a width of the first line-like conductor layer in its cross-sectional view, and $W_2$ is a width of the second line-like conductor layer in its cross-sectional view.

5.  The wiring body according to any one of claims 1 to 4, wherein a thickness $W_1$ of the first line-like conductor layer is 10 $\mu$m or less.

6.  The wiring body according to any one of claims 1 to 5, wherein
    a first adhesion surface between the first line-like conductor layer and the resin layer is convexly curved toward the first line-like conductor layer in its cross-sectional view,
    a second adhesion surface between the second line-like conductor layer and the resin layer is convexly curved toward the second line-like conductor layer in its cross-sectional view, and
    a following Expression (4) is satisfied:

$$R_1 < R_2 \ \ldots (4)$$

where $R_1$ is a curvature of the first adhesion surface, and $R_2$ is a curvature of the second adhesion surface.

7.  The wiring body according to any one of claims 1 to 6, wherein a following Expression (5) is satisfied:

$$S_1 < S_2 \ldots (5)$$

where $S_1$ is a thickness of the resin layer at an adhesion portion with the first line-like conductor layer, and $S_2$ is a thickness of the resin layer at an adhesion portion with the second line-like conductor layer.

8. The wiring body according to any one of claims 1 to 7, wherein a surface of the first line-like conductor layer at the one side is located at a side departing from the resin layer in a thickness direction of the resin layer as compared with at least a part of a second adhesion surface between the second line-like conductor layer and the resin layer.

9. The wiring body according to any one of claims 1 to 8, wherein
the first line-like conductor layer and the second line-like conductor layer connect to each other in a connection portion between the electrode layer and the lead wiring layer, and
a thickness of a conductor portion in the connection portion increases continuously toward the second line-like conductor layer from the first line-like conductor layer.

10. The wiring body according to any one of claims 1 to 9, wherein
the electrode layer has the first line-like conductor layers provided on the surface of the resin layer at the one side, and
a shape of the electrode layer in its plan view is a mesh shape configured by the first line-like conductor layers.

11. The wiring body according to any one of claims 1 to 10, wherein
the lead wiring layer has the second line-like conductor layers provided on the surface of the resin layer at the one side, and
a shape of the lead wiring layer in its plan view is a mesh shape configured by the second line-like conductor layers.

12. A wiring board comprising:

the wiring body according to any one of claims 1 to 11; and
a support body supporting the wiring body.

13. A touch sensor comprising the wiring board according to claim 12.

14. A production method for a wiring body, the wiring body including an electrode layer and a lead wiring layer formed integrally with the electrode layer, the production method comprising:

a first step of filling a recess of a recessed plate with a conductive material;
a second step of performing at least one of drying, heating, and irradiation with energy rays to the conductive material with which the recess is filled;
a third step of disposing a resin on the conductive material; and
a fourth step of releasing at least the resin and the conductive material from the recessed plate, wherein
the recess includes:

a first recess corresponding to a shape of the electrode layer; and
a second recess corresponding to a shape of the lead wiring layer,
the lead wiring layer has a single-layer structure made of a material having same composition as that of a material of which the electrode layer is made,
a following Expression (6) is satisfied:

$$D_1 < D_2 \ldots (6)$$

where $D_1$ is a depth of the first recess and $D_2$ is a depth of the second recess.

Fig.1

EP 3 264 235 A1

Fig.2

Fig.3

EP 3 264 235 A1

Fig.4

Fig.5

EP 3 264 235 A1

Fig.6

EP 3 264 235 A1

Fig.7 (A)

Fig.7 (B)

Fig.7 (C)

Fig.7 (D)

Fig.7 (E)

# INTERNATIONAL SEARCH REPORT

| | International application No. |
|---|---|
| | PCT/JP2016/055931 |

**A. CLASSIFICATION OF SUBJECT MATTER**

*G06F3/041*(2006.01)i, *G06F3/044*(2006.01)i, *H05K1/02*(2006.01)i, *H05K3/12*(2006.01)i, *H05K3/20*(2006.01)i

According to International Patent Classification (IPC) or to both national classification and IPC

**B. FIELDS SEARCHED**

Minimum documentation searched (classification system followed by classification symbols)
G06F3/041, G06F3/044, H05K1/02, H05K3/12, H05K3/20

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2016 |
| Kokai Jitsuyo Shinan Koho | 1971-2016 | Toroku Jitsuyo Shinan Koho | 1994-2016 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2006-302930 A (Matsushita Electric Industrial Co., Ltd.), 02 November 2006 (02.11.2006), paragraphs [0001] to [0080]; fig. 1 to 5 & US 2008/0135283 A1 paragraphs [0266] to [0312]; fig. 13 to 17 & WO 2006/112384 A1 & CN 101156238 A | 1-14 |
| Y | JP 2012-146134 A (Dainippon Printing Co., Ltd.), 02 August 2012 (02.08.2012), paragraphs [0030] to [0056]; fig. 2 to 4 (Family: none) | 1-14 |

| ☒ Further documents are listed in the continuation of Box C. | ☐ See patent family annex. |
|---|---|

| * Special categories of cited documents: | |
|---|---|
| "A" document defining the general state of the art which is not considered to be of particular relevance | "T" later document published after the international filing date or priority date and not in conflict with the application but cited to understand the principle or theory underlying the invention |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 09 May 2016 (09.05.16) | 17 May 2016 (17.05.16) |

| Name and mailing address of the ISA/ Japan Patent Office 3-4-3,Kasumigaseki,Chiyoda-ku, Tokyo 100-8915,Japan | Authorized officer |
|---|---|
| | Telephone No. |

Form PCT/ISA/210 (second sheet) (January 2015)

# EP 3 264 235 A1

**INTERNATIONAL SEARCH REPORT**

International application No.

PCT/JP2016/055931

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 2012-168301 A  (Bridgestone Corp.),<br>06 September 2012 (06.09.2012),<br>paragraphs [0018] to [0040], [0068] to [0076];<br>fig. 1 to 2<br>(Family: none) | 1-14 |
| Y<br>A | JP 7-169635 A  (Matsushita Electric Industrial<br>Co., Ltd.),<br>04 July 1995 (04.07.1995),<br>paragraphs [0001], [0109] to [0114]; fig. 13<br>& US 5609704 A<br>column 1, lines 6 to 11; column 16, line 8 to<br>column 17, line 15; fig. 13<br>& US 6310304 B1          & US 6378424 B1 | 4-13<br>1-3,14 |
| Y<br>A | US 2014/0307178 A1  (SHENZHEN O-FILM TECH CO.,<br>LTD.),<br>16 October 2014 (16.10.2014),<br>paragraphs [0055] to [0058]; fig. 6 to 9<br>& JP 2015-515709 A      & WO 2014/166175 A1<br>& CN 103412668 A        & TW 201439840 A<br>& KR 10-2014-0132264 A | 5-13<br>1-4,14 |

Form PCT/ISA/210 (continuation of second sheet) (January 2015)

27

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2015038637 A

- JP 4436441 B